# EUROPEAN PATENT SPECIFICATION

(11) **EP 2 258 890 B1**
(45) Date of publication and mention of the grant of the patent: **12.02.2014**
(21) Application number: 08871941.4
(22) Date of filing: 24.12.2008
(51) Int. Cl.: C30B 29/38, C30B 23/06, H01L 21/205

(54) **METHOD FOR GROWING AlxGa1-xN SINGLE CRYSTAL**
VERFAHREN ZUM ZIEHEN EINES ALXGA1-XN-EINKRISTALLS
PROCÉDÉ POUR LA CROISSANCE D'UN MONOCRISTAL D'AlxGa1-xN

(30) Priority: 31.01.2008 JP 2008021477
(43) Date of publication of application: 08.12.2010
(73) Proprietor: Sumitomo Electric Industries, Ltd., Chuo-ku Osaka-shi Osaka 541-0041 (JP)
(72) Inventor: MIYANAGA, Michimasa, Itami-shi Hyogo 664-0016 (JP); MIZUHARA, Naho, Itami-shi Hyogo 664-0016 (JP); TANIZAKI, Keisuke, Itami-shi Hyogo 664-0016 (JP); KAWASE, Tomohiro, Itami-shi Hyogo 664-0016 (JP); NAKAHATA, Hideaki, Itami-shi Hyogo 664-0016 (JP)
(74) Representative: Grünecker, Kinkeldey, Stockmair & Schwanhäusser
(86) International application number: PCT/JP2008/073365
(87) International publication number: WO 2009/096123

(56) References cited:
- EP-A2- 2 000 567
- WO-A1-2007/080881
- WO-A1-2008/088838
- JP-A- 2003 218 043
- JP-A- 2003 277 183
- JP-A- 2006 335 608
- US-A- 3 634 149
- US-A- 4 489 128
- US-A1- 2004 187 766
- LIU B ET AL: "Free nucleation of aluminum nitride single crystals in HPBN crucible by sublimation", MATERIALS SCIENCE AND ENGINEERING B, ELSEVIER SEQUOIA, LAUSANNE, CH, vol. 117, no. 1, 25 February 2005 (2005-02-25), pages 99-104, XP025305029, ISSN: 0921-5107, DOI: DOI:10.1016/J.MSEB.2004.10.009 [retrieved on 2005-02-25]
- ZHUANG D ET AL: "Seeded growth of AlN single crystals by physical vapor transport", JOURNAL OF CRYSTAL GROWTH, ELSEVIER, AMSTERDAM, NL, vol. 287, no. 2, 25 January 2006 (2006-01-25), pages 372-375, XP025156873, ISSN: 0022-0248, DOI: DOI:10.1016/J.JCRYSGRO.2005.11.047 [retrieved on 2006-01-25]
- SCHLESSER R ET AL: "Seeded growth of AlN bulk single crystals by sublimation", JOURNAL OF CRYSTAL GROWTH, ELSEVIER, AMSTERDAM, NL, vol. 241, no. 4, 1 June 2002 (2002-06-01), pages 416-420, XP004360665, ISSN: 0022-0248, DOI: DOI:10.1016/S0022-0248(02)01319-2

## Description

### Technical Field

The present invention relates to methods of growing large-scale Al*ₓ*Ga_{1-*x*}N (0 < *x* ≤ 1, same hereinafter) single crystal of good crystalline quality advantageously employed in semiconductor substrates, etc.

### Background Art

Al*ₓ*Ga_{1-*x*}N single crystal and other Group III-nitride crystal is extraordinarily useful as a material for forming optoelectronic devices, microelectronic devices, semiconductor sensors, and similar semiconductor devices.

As a means in order to produce such Al*ₓ*Ga_{1-*x*}N single crystal, vapor-phase deposition, especially sublimation growth, has been proposed from the perspective of obtaining high-quality single crystals whose diffraction-peak full-width at half-maximum in x-ray diffraction rocking curves is narrow. In the specification for U.S. Pat. No. 5,858,086 (Patent Document 1), for example, the growing of AlN single crystal at the high growth rate of 0.5 mm/hr by sublimation or similar vapor-phase deposition techniques is disclosed. And in the specification for U.S. Pat. No. 6,296,956 (Patent Document 2), AlN bulk single crystal whose crystal diameter is 1 inch (25.4 mm) or more and in which the proportion of contained impurities is 450 ppm or less, grown by sublimation onto a seed crystal, is disclosed. Lastly, in the specification for U.S. Pat. No. 6,001,748 (Patent Document 3), AlN crystal of 10 mm or longer length, 10 mm or greater width, and 300 µm or greater thickness, grown by sublimation, is disclosed.

When attempts have been made to produce large-scale (for example, 1-inch (25.4 mm) diameter × 2-mm or greater thickness, same hereinafter) Al*ₓ*Ga_{1-*x*}N single crystal by sublimation, however, the crystal growth has proven to be non-uniform, which has led to such problems as significant increase in dislocations, degradation in the crystal quality, and generation of polycrystal, such that a method of stably growing low-dislocation-density, high-quality Al*ₓ*Ga_{1-*x*}N single crystal of practically useable size has yet to be proposed.
*Patent Document 1*: U.S. Pat. No. 5,858,086
*Patent Document 2*: U.S. Pat. No. 6,296,956
*Patent Document 3*: U.S. Pat. No. 6,001,748

US2004187766 teaches a method of manufacturing large area crystals of SiC, AIN and GaN by using multiple thin seed, this large crystal being further used as seed during sublimation method.

EP2000567 teaches a method of growing by sublimation a III-nitride single crystal using a group IVB element (C, Si, Ge...) as dopant.

### Disclosure of Invention

### Problems Invention Is to Solve

Al*ₓ*Ga_{1-*x*}N (0 < *x* ≤ 1) single crystal is generally grown employing sublimation growth. As far as this sublimation growth is concerned, the ways in which crystal is grown fall into a category in which crystal nuclei are created, without employing a template crystal, and the crystal nuclei are grown (hereinafter, "crystal-nuclei growth category"), and a category in which crystal is grown onto a template crystal (hereinafter, "on-template-crystal crystal growth category"). Herein, with the on-template-crystal crystal growth category, due to the difficulty of procuring large-area Al*ₓ*Ga_{1-*x*}N (0 < *x* ≤ 1) substrates, nonnative template crystal, such as SiC crystal, whose chemical composition differs from that of the Al*ₓ*Ga_{1-*x*}N single crystal that is grown, is employed.

With the on-template-crystal crystal growth category employing nonnative template crystal, while scaling up to comparatively larger sizes is facilitated, the downside is that dislocations and similar defects arise due to the mismatch in lattice constant and thermal expansion coefficient between the nonnative template crystal and the Al*ₓ*Ga_{1-*x*}N single crystal grown onto it, as a consequence of which ordinarily only low-quality crystal can be obtained. With the crystal-nuclei growth category, on the other hand, high-quality crystal can be easily obtained, but not employing a template crystal is prohibitive of stably obtaining large-area bulk crystal, which has in general made it difficult to manufacture large-scale, high-quality crystal that can be put to practical use.

Given these circumstances, utilizing as a seed crystal large-area Al*_{y}*Ga_{1-*y*}N (0 < *y* ≤ 1, same hereinafter) crystal would be desirable, to the extent that it is procurable as template crystal. Even if such Al*_{y}*Ga_{1-*y*}N seed crystal is procured, however, owing to differences in such factors as the crystal-growth technique, the crystal-growth conditions, the chemical composition (that is, the type and percent-fraction of the atoms constituting the crystal), and the level of impurities, stress develops between the seed crystal and the single crystal grown onto the seed crystal, giving rise to dislocations and like defects, and to cracks, warping, etc. in the single crystal that is grown.

An object of the present invention is to resolve the problematic issues discussed above by making available a method of growing large-scale, high-quality Al*ₓ*Ga_{1-*x*}N single crystal.

### Means for Resolving the Problems

The present invention is an Al*ₓ*Ga_{1-*x*}N single crystal growth method provided with: a step of preparing an Al*_{y}*Ga_{1-*y*}N (0 < *y* ≤ 1) seed crystal whose crystal diameter *D* mm and thickness Tmm satisfy the relation *T* < 0.003*D* + 0.15; and a step of growing Al*ₓ*Ga_{1-*x*}N (0 < *x* ≤ 1) single crystal onto a major surface of the Al*_{y}*Ga_{1-*y*}N seed crystal by sublimation growth, wherein the Al*_{y}*Ga_{1-*y*}N seed crystal contains in mass ratio, 10 ppm or more of at least one type of atoms among the Group IVB elements.

In a method, involving the present invention, of growing Al*ₓ*Ga_{1-*x*}N single crystal, crystal nuclei for the Al*_{y}*Ga_{1-*y*}N seed crystal may be created by sublimation growth, and the crystal nuclei grown into the Al*_{y}*Ga_{1-*y*}N seed crystal. Furthermore, the Al*_{y}*Ga_{1-*y*}N seed crystal can have a (0001) surface as its major surface.

### Effects of the Invention

The present invention, enables the provision of a method of growing large-scale, high-quality Al*ₓ*Ga_{1-*x*}N single crystal.

### Brief Description of Drawings

Fig. 1 is a simplified, sectional view for setting forth one mode of embodying a method of growing Al*ₓ*Ga_{1-*x*}N single crystal.
Fig. 2 is a simplified, sectional view for setting forth one mode of embodying a method of growing Al*_{y}*Ga_{1-*y*}N seed crystal.
Fig. 3 is a simplified, sectional view for setting forth another mode of embodying a method of growing Al*_{y}*Ga_{1-*y*}N seed crystal.
Fig. 4 is a graph plotting the relationship between crystal diameter *D* mm and thickness *T* mm of Al*_{y}*Ga_{1-*y*}N seed crystal in embodiment and comparison examples.

### Legend

**1:** template crystal
**1*m*, 4*m:*** major surfaces
**2:** Al*ₛ*Ga_{1-*s*}N source material
**3:** Al*ₜ*Ga_{1-*t*}N source material
**4:** Al*_{y}*Ga_{1-*y*}N seed crystal
**5:** Al*ₓ*Ga_{1-*x*}N single crystal
**10:** sublimation furnace
**11:** reaction chamber
**11*a*:** N₂ gas introduction port
**11*c*:** N₂ gas exhaust port
**12:** crucible
**12*c*:** ventilation port
**12*p*:** crucible lid-plate
**12*q*:** crucible body
**13:** heating element
**14:** RF heating coil
**15:** radiation thermometer

### Best Mode for Carrying Out the Invention

Hereinafter, referring to the accompanying drawings, an explanation of embodiments of the present invention will be made in detail. It should be understood that in describing the drawings, with the same reference marks being used for identical or equivalent features, reduplicating description will be omitted. Furthermore, the dimensional proportions in the drawings do not necessarily agree with what is described.

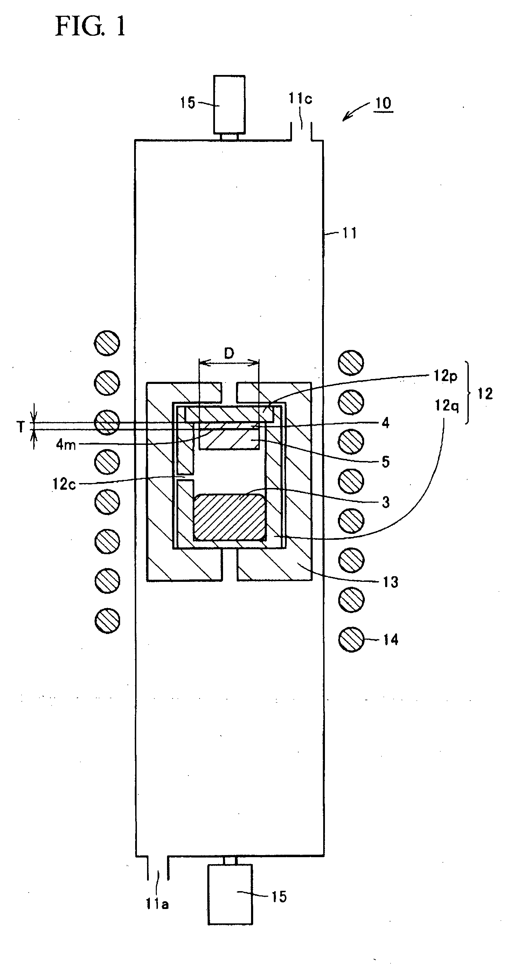

Reference is made to Fig. 1. One mode of embodying a method of growing Al*ₓ*Ga_{1-*x*}N single crystal involving the present invention provides: a step of preparing an Al*_{y}*Ga_{1-*y*}N (0 < *y* ≤ 1) seed crystal 4 whose crystal diameter *D* (units: mm) and thickness *T* (units: mm) satisfy the relation *T* < 0.003D + 0.15; and a step of growing Al*ₓ*Ga_{1-*x*}N (0 < *x* ≤ 1) single crystal 5 onto a major surface 4*m* of the Al*_{y}*Ga_{1-*y*}N seed crystal 4 by sublimation growth. Growing Al*ₓ*Ga_{1-*x*}N single crystal onto a major surface of trim-thickness Al*_{y}*Ga_{1-*y*}N seed crystal whose crystal diameter *D* (mm) and thickness *T* (mm) satisfy the relation *T* < 0.003*D* + 0.15 alleviates stress arising within the Al*ₓ*Ga_{1-*x*}N single crystal that grows onto the Al*_{y}*Ga_{1-*y*}N seed crystal, stopping dislocation and similar defects, and cracks, warpage, etc. from occurring in the Al*ₓ*Ga_{1-*x*}N single crystal that is grown, to yield large-scale, high-quality Al*ₓ*Ga_{1-*x*}N single crystal. This result is especially effective when the thickness of the Al*ₓ*Ga_{1-*x*}N single crystal is 1 mm or more.

Herein, while the mole ratios of the Al*_{y}*Ga_{1-*y*}N seed crystal and the Al*ₓ*Ga_{1-*x*}N single crystal that is grown may be the same (i.e., *y* = *x*) or may differ (i.e., *y* ≠ *x*), from the perspective of reducing stress that occurs within the crystal during growth of the Al*ₓ*Ga_{1-*x*}N single crystal, it is preferable that the difference in mole ratios (i.e., |*y* - *x*|) be small, and it is more preferable that the mole ratios be the same (i.e., *y* = *x*).

Reference is made to Fig. 1. An Al*ₓ*Ga_{1-*x*}N single crystal growth method of the present embodying mode is provided with a step of preparing an Al*_{y}*Ga_{1-*y*}N (0 < *y* ≤ 1) seed crystal 4 whose crystal diameter *D* (mm) and thickness *T* (mm) satisfy the relation *T* < 0.003*D* + 0.15. The crystal diameter *D* (mm) and thickness *T* (mm) of the Al*_{y}*Ga_{1-*y*}N seed crystal satisfying the relation *T* < 0.003D + 0.15 makes possible during the growth of Al*ₓ*Ga_{1-*x*}N single crystal the alleviation of stress developing within the Al*ₓ*Ga_{1-*x*}N single crystal that grows onto the Al*_{y}*Ga_{1-*y*}N seed crystal. From that perspective, the crystal diameter *D* (mm) and thickness *T* (mm) of the Al*_{y}*Ga_{1-*y*}N seed crystal preferably satisfy the relation *T* < 0.002*D* + 0.1.

Furthermore, given the considerations discussed above, the thickness *T* (mm) of the Al*_{y}*Ga_{1-*y*}N seed crystal preferably is less than 0.25 mm, more preferably is less than 0.2 mm, and still more preferably is less than 0.15 mm. Likewise, from the viewpoint of ease of handling, the thickness *T* (mm) of the Al*_{y}*Ga_{1-*y*}N seed crystal preferably is 0.01 mm or greater, and more preferably is 0.05 mm or greater.

There are no particular limitations on the step of preparing the Al*_{y}*Ga_{1-*y*}N seed crystal; a vapor-phase technique such as sublimation growth, or a liquid-phase technique such as solution growth (including flux growth) can be employed to grow bulk crystal, and then the bulk crystal can be processed in such a way that the crystal diameter *D* (mm) and thickness *T* (mm) satisfy the relation *T* < 0.003*D* + 0.15.

And from the perspective of reducing dislocations and like defects within the Al*_{y}*Ga_{1-*y*}N seed crystal, as well as warpage and cracking, preferably a material is prepared as the seed crystal in which crystal nuclei for the Al*_{y}*Ga_{1-*y*}N seed crystal are created by sublimation growth, and the crystal nuclei are grown. In addition, from the perspective of reducing dislocations within the seed crystal and reducing dislocation and like defects in the Al*ₓ*Ga_{1-*x*}N single crystal that is grown, the geometry of the Al*_{y}*Ga_{1-*y*}N seed crystal obtained by growing the crystal nuclei preferably satisfies the relation *D* ≥ 3 for crystal diameter *D* (mm) and thickness *T* (mm), and more preferably satisfies the relation *T* < 0.003D + 0.15.

Fig. is again referred to. An Al*ₓ*Ga_{1-*x*}N single crystal growth method of the present embodying mode is provided with a step of growing Al*ₓ*Ga_{1-*x*}N single crystal 5 onto a major surface 4*m* of the Al*_{y}*Ga_{1-*y*}N seed crystal 4 by sublimation growth. Growing Al*ₓ*Ga_{1-*x*}N single crystal onto the major surface of such Al*_{y}*Ga_{1-*y*}N seed crystal enables the alleviation of stress developing within the Al*ₓ*Ga_{1-*x*}N single crystal, stopping occurrence of dislocations and like defects, as well as warping and cracks, to yield large-scale, high-quality Al*ₓ*Ga_{1-*x*}N single crystal.

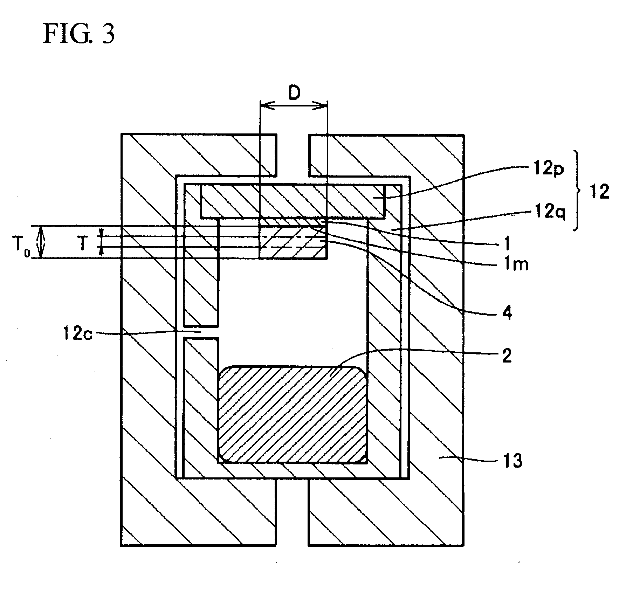

The sublimation technique is classified by the following two categories of crystal growth. One category, with reference to Fig. 1 and Fig. 3, is a type of sublimation in which crystal is grown onto a major surface of a template crystal (hereinafter, "on-template-crystal crystal growth category"). For example, referring to Fig. 1, an Al*ₜ*Ga_{1-*t*}N (0 < *t* ≤ 1, same hereinafter) source material 3 is sublimed and then re-hardened to grow Al*ₓ*Ga_{1-*x*}N (0 < *x* < 1) single crystal 5 onto the major surface 4*m* of an Al*_{y}*Ga_{1-*y*}N seed crystal as a template crystal. Likewise, referring to Fig. 3, an Al*ₛ*Ga_{1-*s*}N (0 < *s* ≤ 1, same hereinafter) source material 2 is sublimed and then re-hardened to grow an Al*_{y}*Ga_{1-*y*}N seed crystal 4 onto a major surface 1*m* of a template crystal 1 such as SiC crystal or Al₂O₃ crystal.

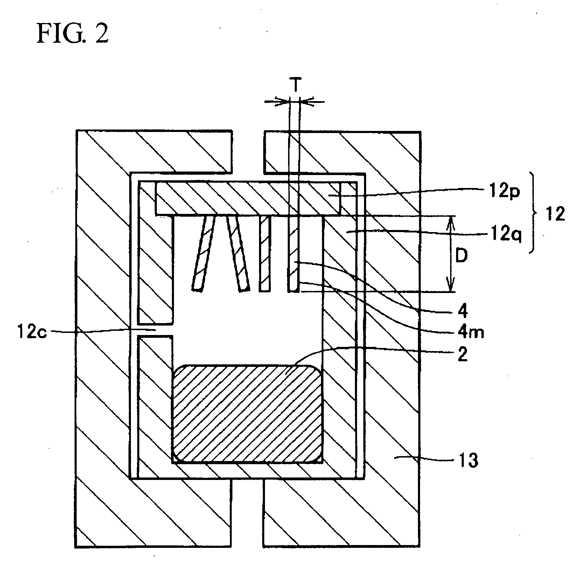

The other category, with reference to Fig. 2, is a type of sublimation in which, without a template crystal being used, crystal nuclei are created, and the crystal nuclei are grown (hereinafter, "crystal-nuclei growth category"). For example, an Al*ₛ*Ga_{1-*s*}N source material 2 is sublimed and re-hardened to create crystal nuclei for Al*_{y}*Ga_{1-*y*}N seed crystal 4, and by growing the crystal nuclei, Al*_{y}*Ga_{1-*y*}N seed crystal 4 is grown.

For the crystal growth in the sublimation (on-template-crystal crystal growth category and crystal-nuclei growth category), a vertical sublimation furnace 10, as represented in Fig. 1, of the radio-frequency heating type is for example employed. In the central portion of a reaction chamber 11 of the vertical sublimation furnace 10, a crucible 12 made of tungsten and having a ventilation port 12*c* is provided, and a heating element 13 made of carbon is provided encompassing the crucible 12 in a manner such as to secure ventilation from the interior of the crucible 12 to the exterior. The crucible 12 is composed of a crucible body 12*q* and a crucible lid-plate 12*p*. Also, in the midportion of the reaction chamber 11 along its outer side, an RF heating coil 14 for heating the heating element 13 is provided. And additionally provided, at the end portions of the reaction chamber 11, are an N₂ gas introduction port 11*a* and an N₂ gas exhaust port 11*c* in order to flow gaseous N₂ onto the exterior of the crucible 12 in the reaction chamber 11, and a radiation thermometer 15 for measuring the temperature of the underside and top side of the crucible.

In a method of growing Al*ₓ*Ga_{1-*x*}N single crystal in the present embodying mode, the step of growing Al*ₓ*Ga_{1-*x*}N single crystal 5 onto the major surface 4*m* of the Al*_{y}*Ga_{1-*y*}N seed crystal 4 is carried out for example as follows, with reference to Fig. 1, employing the above-described vertical sublimation furnace 10.

To begin with, Al*ₜ*Ga_{1-*t*}N source material 3 is stowed in the lower part of the crucible body 12*q*, and the Al*_{y}*Ga_{1-*y*}N seed crystal 4 described earlier is arranged on the inner side of the crucible lid-plate 12*p* in such a way that the seed crystal's major surface 4*m* opposes the Al*ₜ*Ga_{1-*t*}N source material 3. Next, while N₂ gas is flowed in the reaction chamber 11 interior, the RF heating coil 14 is employed to heat the heating element 13, whereby the temperature of the crucible 12 interior is ramped up, and by holding the temperature of the crucible 12 at the Al*ₜ*Ga_{1-*t*}N source material 3 higher than the temperature at the Al*_{y}*Ga_{1-*y*}N seed crystal 4, Al*ₓ*Ga_{1-*x*}N is sublimed from the Al*ₜ*Ga_{1-*t*}N source material 3 and the Al*ₓ*Ga_{1-*x*}N re-hardens onto the major surface 4*m* of the Al*_{y}*Ga_{1-*y*}N seed crystal 4 to grow Al*ₓ*Ga_{1-*x*}N single crystal 5. Herein, the Al sublimation temperature and sublimation pressure, and the Ga sublimation temperature and sublimation pressure respectively differ. While the relationship between the atomic fraction *t* of Al in the Al*ₜ*Ga_{1-*t*}N source material and the atomic fraction *x* of Al in the Al*ₓ*Ga_{1-*x*}N that is sublimed from the Al*ₜ*Ga_{1-*t*}N source material therefore varies depending upon the sublimation temperature, at a given sublimation temperature, a given relationship will hold.

Herein, throughout growth of the Al*ₓ*Ga_{1-*x*}N single crystal 5, the temperature of the crucible 12 at the Al*ₜ*Ga_{1-*t*}N source material 3 (hereinafter, also referred to as the sublimation temperature) is made some 1600°C to 2300°C, and by having the temperature of the crucible 12 at the Al*_{y}*Ga_{1-*y*}N seed crystal 4 (hereinafter, also referred to as the crystal-growth temperature) be some 10°C to 200°C lower than the temperature at the Al*ₜ*Ga_{1-*t*}N source material 3 (the sublimation temperature), high-quality Al*ₓ*Ga_{1-*x*}N single crystal 5 is obtained. Furthermore, also throughout the crystal growth, along the outside of the crucible 12 in the reaction chamber 11 interior, N₂ gas is continually flowed in such a way that the gas partial pressure will be some 101.3 hPa to 1013 hPa, whereby mixing of impurities into the Al*ₓ*Ga_{1-*x*}N single crystal 5 can be reduced.

It should be noted that, throughout elevation of the crucible 12 interior-area temperature, making the temperature of the region of the crucible 12 interior apart from the Al*ₜ*Ga_{1-*t*}N source material 3 higher than the temperature of the crucible 12 at the source material enables exhausting of impurities in the crucible 12 interior area via the ventilation port 12c, making it possible further to reduce mixing of impurities into the Al*ₓ*Ga_{1-*x*}N single crystal 5.

The Al*_{y}*Ga_{1-*y*}N seed crystal utilized in a method of manufacturing Al*ₓ*Ga_{1-*x*}N single crystal in the present embodying mode preferably is Al*_{y}*Ga_{1-*y*}N seed-crystal crystal nuclei created by sublimation, and those crystal nuclei having been grown (in other words, the crystal-nuclei growth category). By said sublimation growth, high-quality Al*_{y}*Ga_{1-*y*}N seed crystal whose crystal diameter *D* (mm) and thickness *T* (mm) satisfy the relation *T* < 0.003D + 0.15 can be obtained.

With reference to Fig. 2, the step of growing Al*_{y}*Ga_{1-*y*}N seed crystal 4 by the sublimation-growth creating of crystal nuclei for Al*_{y}*Ga_{1-*y*}N seed crystal 4 and the growing of those crystal nuclei is carried out, for example, in the following manner.

To begin with, Al*ₛ*Ga_{1-*s*}N source material 2 is stowed in the lower part of the crucible body 12*q*, and the crucible lid-plate 12*p* is arranged so as to oppose the Al*ₛ*Ga_{1-*s*}N source material 2. Next, with reference to Fig. 1 and Fig. 2, while N₂ gas is flowed in the reaction chamber 11 interior, the RF heating coil 14 is employed to heat the heating element 13, whereby the temperature of the crucible 12 interior is ramped up, and by holding the temperature of the crucible 12 at the Al*ₛ*Ga_{1-*s*}N source material 2 higher than the temperature along the crucible lid-plate 12*p*, Al*_{y}*Ga_{1-*y*}N is sublimed from the Al*ₛ*Ga_{1-*s*}N source material 2 and the Al*_{y}*Ga_{1-*y*}N re-hardens onto the crucible lid-plate 12p, creating Al*_{y}*Ga_{1-y}N seed-crystal crystal nuclei and growing those crystal nuclei, whereby Al*_{y}*Ga_{1-*y*}N seed crystal 4 is grown. Herein, the Al sublimation temperature and sublimation pressure, and the Ga sublimation temperature and sublimation pressure respectively differ. While the relationship between the atomic fraction s of Al in the Al*ₛ*Ga_{1-*s*}N source material and the atomic fraction *y* of Al in the Al*_{y}*Ga_{1-*y*}N that is sublimed from the Al*ₛ*Ga_{1-*s*}N source material therefore varies depending upon the sublimation temperature, at a given sublimation temperature, a given relationship will hold.

Herein, throughout growth of the Al*_{y}*Ga_{1-*y*}N seed crystal, the temperature of the crucible 12 at the Al*ₛ*Ga_{1-*s*}N source material 2 (the sublimation temperature) is made some 1600°C to 2300°C, and by having the temperature of the crucible 12 at the crucible lid-plate 12*p* (the crystal-growth temperature) be some 10°C to 200°C lower than the temperature at the Al*ₛ*Ga_{1-*s*}N source material 2 (the sublimation temperature), high-quality Al_{y}Ga_{1-*y*}N seed crystal 4 is obtained. Furthermore, also throughout the crystal growth, along the outside of the crucible 12 in the reaction chamber 11 interior, N₂ gas is continually flowed in such a way that the gas partial pressure will be some 101.3 hPa to 1013 hPa, whereby mixing of impurities into the Al*_{y}*Ga_{1-*y*}N seed crystal 4 can be reduced.

It should be noted that, throughout elevation of the crucible 12 interior-area temperature, making the temperature of the region apart from the Al*ₛ*Ga_{1-*s*}N source material 2 higher than the temperature of the crucible 12 at the source material enables elimination of impurities in the crucible 12 interior area via the ventilation port 12*c*, making it possible further to reduce mixing of impurities into the Al*_{y}*Ga_{1-*y*}N seed crystal 4.

The Al*_{y}*Ga_{1-*y*}N seed crystal 4 grown in the manner described above has, with reference to Fig. 2, a hexagonal flat-platelike or other polygonal flat-platelike geometry, with the polygonal flat-platelike crystal adhering in an upright state onto the crucible lid-plate 12*p*.

Also, the Al*_{y}*Ga_{1-*y*}N seed crystal utilized in a method of manufacturing Al*ₓ*Ga_{1-*x*}N single crystal in the present embodying mode may be Al*_{y}*Ga_{1-*y*}N seed crystal grown onto a major surface of a template crystal by sublimation growth (i.e., the on-template-crystal crystal growth category). With reference to Fig. 3, the step of growing Al*_{y}*Ga_{1-*y*}N seed crystal 4 onto a major surface 1*m* of a template crystal 1 by sublimation growth is carried out, for example, in the following manner.

To begin with, an Al*ₛ*Ga_{1-*s*}N source material 2 is stowed the lower part of the crucible body 12*q*, and an SiC crystal, Al₂O₃ crystal, Si crystal, Ga crystal, GaN crystal, ZnO crystal or like template crystal 1 of crystal diameter *D* mm is arranged on the inner side of the crucible lid-plate 12*p* in such a way that the seed crystal's major surface 1*m* opposes the Al*ₛ*Ga_{1-*s*}N source material 2.

Next, while N₂ gas is flowed in the reaction chamber 11 interior, the RF heating coil 14 is employed to heat the heating element 13, whereby the temperature of the crucible 12 interior is ramped up, and by holding the temperature of the crucible 12 at the Al*ₛ*Ga_{1-*s*}N source material 2 higher than the temperature along the template crystal 1, Al*_{y}*Ga_{1-*y*}N is sublimed from the Al*ₛ*Ga_{1-*s*}N source material 2 and the Al*_{y}*Ga_{1-*y*}N re-hardens onto the major surface 1*m* of the template crystal 1 to grow Al*_{y}*Ga_{1-*y*}N seed crystal 4. Herein, the Al sublimation temperature and sublimation pressure, and the Ga sublimation temperature and sublimation pressure respectively differ. While the relationship between the atomic fraction *s* of Al in the Al*ₛ*Ga_{1-*s*}N source material and the atomic fraction *y* of Al in the Al*_{y}*Ga_{1-*y*}N that is sublimed from the Al*ₛ*Ga_{1-*s*}N source material therefore varies depending upon the sublimation temperature, at a given sublimation temperature, a given relationship will hold.

Herein, throughout growth of the Al*_{y}*Ga_{1-*y*}N seed crystal 4, the temperature of the crucible 12 at the Al*ₛ*Ga_{1-*s*}N source material 2 (hereinafter also referred to as sublimation temperature) is made some 1600°C to 2300°C, and by having the temperature of the crucible 12 along the template crystal 1 (hereinafter also referred to as crystal-growth temperature) be some 10°C to 200°C lower than the temperature at the Al*ₛ*Ga_{1-*s*}N source material 2 (the sublimation temperature), high-quality Al*_{y}*Ga_{1-*y*}N seed crystal 4 of crystal diameter *D* (mm) and thickness *T₀* (mm) is obtained. Furthermore, also throughout the crystal growth, along the outside of the crucible 12 in the reaction chamber 11 interior, N₂ gas is continually flowed in such a way that the gas partial pressure will be some 101.3 hPa to 1013 hPa, whereby mixing of impurities into the Al*_{y}*Ga_{1-*y*}N seed crystal 4 can be reduced.

It should be noted that, throughout elevation of the crucible 12 interior-area temperature, making the temperature of the region of the crucible 12 interior apart from the Al*ₛ*Ga_{1-*s*}N source material 2 higher than the temperature of the crucible 12 at the source material enables exhausting of impurities in the crucible 12 interior area via the ventilation port 12*c*, making it possible further to reduce mixing of impurities into the Al*_{y}*Ga_{1-*y*}N seed crystal 4.

By slicing the Al*_{y}*Ga_{1-*y*}N seed crystal 4 of crystal diameter *D* (mm) and thickness *T*₀ (mm), obtained as described above, along planes parallel to its major surface, and by polishing the surfaces where the crystal is sliced, an Al*_{y}*Ga_{1-*y*}N seed crystal 4 whose crystal diameter *D* (mm) and thickness *T* (mm) (herein, *T*₀ > *T*) satisfy the relation *T* < 0.003*D* + 0.15 is obtained.

Herein, the Al*_{y}*Ga_{1-*y*}N seed crystal 4 utilized in a method of growing Al*ₓ*Ga_{1-*x*}N single crystal in the present embodying mode preferably has a (0001) face as the major surface. The Al*_{y}*Ga_{1-*y*}N seed crystal having a (0001) face as the major surface facilitates growth of large-scale Al*ₓ*Ga_{1-*x*}N single crystal onto the major surface of the Al*_{y}*Ga_{1-*y*}N seed crystal. From the perspective of growing high-quality Al*ₓ*Ga_{1-*x*}N single crystal both stably and efficiently, the Al*ₓ*Ga_{1-*x*}N single crystal preferably is grown onto a (0001) Ga face of the Al*_{y}*Ga_{1-*y*}N seed crystal.

The Al*_{y}*Ga_{1-*y*}N seed crystal 4 utilized in a method of growing Al*ₓ*Ga_{1-*x*}N single crystal in the present embodying mode contains, in mass ratio, 10 ppm or more of at least one type of atoms among the Group IVB elements. Herein, Al*_{y}*Ga_{1-*y*}N seed crystal containing 10 ppm (mass ratio) or more of at least one type of atoms among the Group IVB elements readily forms a single-crystal having a (0001) face as the major surface, having a hexagonal flat-platelike or other polygonal flat-platelike geometry, and whose crystal diameter *D* (mm) and thickness *T* (mm) satisfy the relation *T* < 0.003*D* + 0.15. Given such considerations, the inclusion ratio of the at least one type of atoms among the Group IVB elements preferably is 10 ppm or more, more preferably is 50 ppm or more, and still more preferably is 100 ppm or more. By the same token, because an excessive amount of impurities would proliferate defects within the crystal, from the perspective of curtailing an excessive amount of impurities, not greater than 5000 ppm is preferable, and not greater than 500 ppm is more preferable. A Group IVB atomic element herein means a Group IVB element in the long-form periodic table, and specifically refers to carbon (C), silicon (Si), germanium (Ge), tin (Sn) and lead (Pb).

Although there no particular restrictions on how the Al*_{y}*Ga_{1-*y*}N seed crystal containing 10 ppm (mass ratio) or more of at least one type of atoms among the Group IVB elements is grown herein, it can be by growing a Al*ₛ*Ga_{1-*s*}N source material 2 stowed into the crucible 12 together with a substance including at least one type of atoms among the Group IVB elements (hereinafter, IVB-element containing substance). Herein, the inclusion quantity of IVB-element containing substance with respect to the Al*ₛ*Ga_{1-*s*}N source material 2 and the IVB-element-containing-substance total source material is made so that the IVB element-the IVB-element inclusion ratio with respect to the sum of the Al*ₛ*Ga_{1-*s*}N and IVB element-preferably will be 50 ppm or greater, more preferably 500 ppm or greater.

Another preferable condition is that throughout growth of the Al*_{y}*Ga_{1-*y*}N seed crystal, the temperature of the crucible 12 at the Al*ₛ*Ga_{1-*s*}N source material 2 (the sublimation temperature) be 1800°C to 2300°C. Meanwhile, the temperature of the crucible 12 at the crucible lid-plate 12*p* (the crystal-growth temperature) preferably is some 10°C to 250°C lower than the temperature at the Al*ₛ*Ga_{1-*s*}N source material 2 (the sublimation temperature)-that is, the crystal-growth temperature preferably is 1550°C to 2290°C.

Lastly, it is preferable that the diffraction-peak full-width at half-maximum in an x-ray diffraction rocking curve of the Al*_{y}*Ga_{1-*y*}N seed crystal 4 utilized in a method of growing Al*ₓ*Ga_{1-*x*}N single crystal in the present embodying mode be not greater than 150 arcsec, and more preferably, not greater than 50 arcsec. Also, the dislocation density of the Al*_{y}*Ga_{1-*y*}N seed crystal 4 preferably is not greater than 1 × 10⁶ cm⁻². While the method of characterizing the dislocation density of the crystal herein is not particularly limited, it can be for example by determining the density of pits (the "EPD," or etch-pit density) produced by carrying out an etching process on the surface of the crystal. Onto the major surface of high-quality Al*_{y}*Ga_{1-*y*}N seed crystal whose diffraction-peak full-width at half-maximum in an x-ray diffraction rocking curve is not greater than 150 arcsec or whose dislocation density is not greater than 1 × 10⁶ cm⁻², high-quality Al*ₓ*Ga_{1-*x*}N single crystal can be grown.

### Embodiments

### Embodiment 1

### 1. Growth of AlN seed crystal (Al_{y}Ga_{1-y}N seed crystal)

Reference is made to Fig. 3: As source materials powdered AIN (Al*ₛ*Ga_{1-*s*}N source material 2) and powdered Si (Group IVB element) were arranged in the lower part of the tungsten crucible body 12*q*. Herein, the inclusion ratio of the Si powder (Group IVB element) within the source materials was made 300 ppm. Next, on the inner side of the tungsten crucible lid-plate 12*p*, as a template crystal 1 an SiC template crystal of 40 mm crystal diameter was arranged in such a way that its (0001) Si face, which was its major surface 1*m*, would oppose the source materials.

Next, with reference to Fig. 1 and Fig. 3, while N₂ gas was flowed in the reaction chamber 11 interior, the RF heating coil 14 was employed to ramp up the temperature of the crucible 12 interior. Throughout elevation of the crucible 12 interior temperature, the temperature of the crucible 12 at the crucible lid-plate 12*p* was made higher than the temperature at the Al*ₛ*Ga_{1-*s*}N source material 2 to clean the surface of the crucible lid-plate 12*p* during the temperature elevation by etching it, and at the same time to eliminate via the ventilation port 12c impurities released from the crucible 12 interior area during the temperature elevation.

Next, the temperature of the crucible 12 at the Al*ₛ*Ga_{1-*s*}N source material 2 (sublimation temperature) was brought to 1700°C and the temperature along the crucible lid-plate 12*p* (crystal-growth temperature), to 1600°C, to sublime AIN and Si from the source materials and, onto the (0001) Si face (major surface 1*m*) of the SiC template crystal 1 arranged on the inner side of the crucible lid-plate 12*p*, re-harden the AIN to grow AIN seed crystal (Al*_{y}*Ga_{1-*y*}N seed crystal 4). During the growth of the AIN seed crystal (Al*_{y}*Ga_{1-*y*}N seed crystal 4) as well, N₂ gas was continually flowed along the outside of the crucible 12 in the reaction chamber 11 interior, and the amount of N₂ gas introduced and the amount of N₂ gas exhausted were controlled in such a way that the gas partial pressure along the outside of the crucible 12 in the reaction chamber 11 interior would be some 101.3 hPa to 1013 hPa. After AIN seed crystal (Al*_{y}*Ga_{1-*y*}N seed crystal 4) was grown 80 hours under the crystal-growth conditions just described, it was cooled to room temperature (25°C), and the crucible lid-plate 12*p* was taken off, whereupon an AlN seed crystal (Al*_{y}*Ga_{1-*y*}N seed crystal 4) whose crystal diameter *D* was 40 mm and whose *T*₀ thickness was 1 mm had been grown onto the (0001) Si face (major surface 1*m*) of the SiC template crystal 1.

Next the AIN seed crystal was sliced along planes parallel to its major surface, and the surfaces where the crystal was sliced were polished, to yield an AIN seed crystal (Al*_{y}*Ga_{1-*y*}N seed crystal 4) whose crystal diameter *D* was 40 mm and whose thickness *T* was 0.21 mm. The inclusion ratio of Si (Group IVB atoms) in the AIN seed crystal was determined by secondary-ion mass spectroscopy (SIMS), whereat it was 80 ppm. The rocking curve in x-ray diffraction of the AIN seed crystal was determined, whereat the diffraction-peak full-width at half-maximum was 180 arcsec.

### 2. Growth of AlN single crystal (AlₓGa₁₋ₓN single crystal)

Reference is made to Fig. 1: As a source material powdered AlN (Al*ₜ*Ga_{1-*t*}N source material 3) was arranged in the lower part of the tungsten crucible body 12*q*. Next, on the inner side of the tungsten crucible lid-plate 12*p*, the AIN seed crystal (Al*_{y}*Ga_{1-*y*}N seed crystal 4) of 40 mm crystal diameter *D* and 0.21 mm thickness *T* was arranged in such a way that its (0001) Al face, which was its major surface 4*m*, would oppose the AIN powder (Al*ₜ*Ga_{1-*t*}N source material 3).

Next, while N₂ gas was flowed in the reaction chamber 11 interior, the RF heating coil 14 was employed to ramp up the temperature of the crucible 12 interior. Throughout elevation of the crucible 12 interior temperature, the temperature of the crucible 12 at the crucible lid-plate 12*p* was made higher than the temperature at the Al*ₜ*Ga_{1-*t*}N source material 3 to clean the surfaces of the crucible lid-plate 12*p* and the AIN seed crystal (Al*_{y}*Ga_{1-*y*}N seed crystal 4) during the temperature elevation by etching it, and at the same time to eliminate via the ventilation port 12*c* impurities released from the crucible 12 interior area during the temperature elevation.

Next, the temperature of the crucible 12 at the Al*ₜ*Ga_{1-*t*}N source material 3 (sublimation temperature) was brought to 1900°C and the temperature at the Al*_{y}*Ga_{1-*y*}N seed crystal 4 (crystal-growth temperature), to 1800°C, to sublime AIN from the source material, and re-harden the AIN onto the AIN seed crystal (Al*_{y}*Ga_{1-*y*}N seed crystal 4) in the upper part of the crucible 12 to grow AIN single crystal (Al*ₓ*Ga_{1-*x*}N single crystal 5). During the growth of the AIN single crystal (Al*ₓ*Ga_{1-*x*}N single crystal 5) as well, N₂ gas was continually flowed along the outside of the crucible 12 in the reaction chamber 11 interior, and the amount of N₂ gas introduced and the amount of N₂ gas exhausted were controlled in such a way that the gas partial pressure along the outside of the crucible 12 in the reaction chamber 11 interior would be some 101.3 hPa to 1013 hPa. After AIN single crystal (Al*ₓ*Ga_{1-*x*}N single crystal 5) was grown 30 hours under the crystal-growth conditions just described, it was cooled to room temperature (25°C), and the crucible lid-plate 12*p* was taken off, whereupon an AlN single crystal (Al*ₓ*Ga_{1-*x*}N single crystal 5) had been grown onto the major surface 4*m* of the AlN seed crystal (Al*_{y}*Ga_{1-*y*}N seed crystal 4).

The size of the AlN single crystal (Al*ₓ*Ga_{1-*x*}N single crystal 5) was 40 mm in crystal diameter and 4 mm in thickness. The rocking curve in x-ray diffraction of the AlN single crystal was determined, whereat the diffraction-peak full-width at half-maximum was a narrow 220 arcsec. Further, the dislocation density of the AlN single crystal was calculated from an EPD (etch-pit density) measurement, whereat it was a low 5 × 10⁶ cm⁻². In other words, the AlN single crystal of Embodiment 1 was of high quality. The results are tabulated in Table I.

### Embodiment 2

### 1. Growth of AlN seed crystal (Al_{y}Ga_{1-y}N seed crystal)

In the same manner as in Embodiment 1, AlN seed crystal whose crystal diameter *D* was 40 mm and whose *T*₀ thickness was 1 mm was grown. The AlN seed crystal was sliced along planes parallel to its major surface, and the surfaces where the crystal was sliced were polished, to yield an AlN seed crystal whose crystal diameter *D* was 40 mm and whose thickness *T* was 0.24 mm. The inclusion ratio of Si (Group IVB atoms) in the AlN seed crystal was 80 ppm. And the diffraction-peak full-width at half-maximum in an x-ray-diffraction rocking curve characterization of the AlN seed crystal was 180 arcsec.

### 2. Growth of AIN single crystal (AlₓGa₁₋ₓN single crystal)

Next, apart from utilizing the just-described AlN seed crystal (Al*_{y}*Ga_{1-*y*}N seed crystal) of 40 mm crystal diameter *D* and 0.24 mm thickness *T*, AlN single crystal (Al*ₓ*Ga_{1-*x*}N single crystal 5) was grown in the same manner as in Embodiment 1. The size of the obtained AlN single crystal was 40 mm in crystal diameter and 4 mm in thickness. The diffraction-peak full-width at half-maximum in an x-ray-diffraction rocking curve characterization of the AlN single crystal was a narrow 230 arcsec. Meanwhile, the dislocation density of the AlN single crystal was a low 6 × 10⁶ cm⁻². In other words, the AlN single crystal of Embodiment 2 was of high quality. The results are tabulated in Table I.

### Comparative Example 1

### 1. Growth of A AlN seed crystal (Al_{y}Ga_{1-y}N seed crystal)

With the exception of employing an SiC template crystal whose crystal diameter was 20 mm, AlN seed crystal whose crystal diameter *D* was 20 mm and whose To thickness was 1 mm was grown in the same manner as in Embodiment 1. The AlN seed crystal was sliced along planes parallel to its major surface, and the surfaces where the crystal was sliced were polished, to yield an AlN seed crystal whose crystal diameter *D* was 20 mm and whose thickness *T* was 0.25 mm. The inclusion ratio of Si (Group IVB atoms) in the AlN seed crystal was 80 ppm. And the diffraction-peak full-width at half-maximum in an x-ray-diffraction rocking curve characterization of the AlN seed crystal was 160 arcsec.

### 2. Growth of AlN single crystal (AlₓGa₁₋ₓN single crystal)

Next, apart from using the just-described AlN seed crystal (Al*_{y}*Ga_{1-*y*}N seed crystal) of 20 mm crystal diameter *D* and 0.25 mm thickness *T*, AlN single crystal (Al*ₓ*Ga_{1-*x*}N single crystal 5) was grown in the same manner as in Embodiment 1. The size of the obtained AlN single crystal was 20 mm in crystal diameter and 4 mm in thickness. The diffraction-peak full-width at half-maximum in an x-ray-diffraction rocking curve characterization of the AlN single crystal was a large 350 arcsec. Meanwhile, the dislocation density of the AlN single crystal was a high 5 × 10⁷ cm⁻². In other words, the AlN single crystal of Comparative Example 1 was of low quality. The results are tabulated in Table 1.

### Comparative Example 2

### 1. Growth of AlN seed crystal (Al_{y}Ga_{1-y}N seed crystal)

With the exception of using only the powdered AlN (Al*ₛ*Ga_{1-*s*}N source material 2) as a source material, AlN seed crystal whose crystal diameter *D* was 40 mm and whose *T*₀ thickness was 1 mm was grown in the same manner as in Embodiment 1. The AlN seed crystal was sliced along planes parallel to its major surface, and the surfaces where the crystal was sliced were polished, to yield an AlN seed crystal whose crystal diameter *D* was 40 mm and whose thickness *T* was 0.32 mm. And the diffraction-peak full-width at half-maximum in an x-ray-diffraction rocking curve characterization of the AlN seed crystal was a large 280 arcsec.

### 2. Growth of AlN single crystal (AlₓGa₁₋ₓN single crystal)

Next, apart from using the just-described AlN seed crystal (Al*_{y}*Ga_{1-*y*}N seed crystal) of 40 mm crystal diameter *D* and 0.32 mm thickness *T*, AlN single crystal (Al*ₓ*Ga_{1-*x*}N single crystal 5) was grown in the same manner as in Embodiment 1. The size of the obtained AlN single crystal was 40 mm in crystal diameter and 4 mm in thickness. The diffraction-peak full-width at half-maximum in an x-ray-diffraction rocking curve characterization of the AlN single crystal was a large 460 arcsec. Meanwhile, the dislocation density of the AlN single crystal was a high 1 × 10⁸ cm⁻². In other words, the AlN single crystal of Comparative Example 2 was of low quality. The results are tabulated in Table I.

### Embodiment 3

### 1. Growth of AlN seed crystal (Al_{y}Ga_{1-y}N seed crystal)

Reference is made to Fig. 2: As source materials powdered AlN (Al*ₛ*Ga_{1-*s*}N source material 2) and powdered Si (Group IVB element) were arranged in the lower part of the tungsten crucible body 12*q*. Herein, the inclusion ratio of the Si powder (Group IVB element) within the source materials was made 500 ppm. Next, the tungsten crucible lid-plate 12*p* was arranged so as to oppose the source materials.

Next, with reference to Fig. 1 and Fig. 2, while N₂ gas was flowed in the reaction chamber 11 interior, the RF heating coil 14 was employed to ramp up the temperature of the crucible 12 interior. Throughout elevation of the crucible 12 interior temperature, the temperature of the crucible 12 at the crucible lid-plate 12*p* was made higher than the temperature at the Al*ₛ*Ga_{1-*s*}N source material 2 to clean the surface of the crucible lid-plate 12*p* during the temperature elevation by etching it, and at the same time to eliminate via the ventilation port 12*c* impurities released from the crucible 12 interior area during the temperature elevation.

Next, the temperature of the crucible 12 at the Al*ₛ*Ga_{1-*s*}N source material 2 (sublimation temperature) was brought to 2200°C and the temperature along the crucible lid-plate 12*p* (crystal-growth temperature), to 2150°C, to sublime AlN and Si from the source materials, and re-harden the AlN onto the crucible lid-plate 12*p* in the upper part of the crucible 12 to grow AlN seed crystal (Al*_{y}*Ga_{1-*y*}N seed crystal 4). During the growth of the AlN seed crystal (Al*_{y}*Ga_{1-*y*}N seed crystal 4) as well, N₂ gas was continually flowed along the outside of the crucible 12 in the reaction chamber 11 interior, and the amount of N₂ gas introduced and the amount of N₂ gas exhausted were controlled in such a way that the gas partial pressure along the outside of the crucible 12 in the reaction chamber 11 interior would be some 101.3 hPa to 1013 hPa. After AlN seed crystal (Al*_{y}*Ga_{1-*y*}N seed crystal 4) was grown 15 hours under the crystal-growth conditions just described, it was cooled to room temperature (25°C), and the crucible lid-plate 12*p* was taken off, whereupon a plurality of hexagonal flat-platelike AlN seed crystals (Al*_{y}*Ga_{1-*y*}N seed crystals 4) had been grown onto the inner side of the crucible lid-plate 12p.

The size of a single AlN seed crystal among the plurality AlN seed crystals (Al*_{y}*Ga_{1-*y*}N seed crystals 4) just described was 25 mm in crystal diameter *D* and 0.16 mm in thickness *T*. The inclusion ratio of Si (Group IVB atoms) in the AlN seed crystal was 150 ppm. The diffraction-peak full-width at half-maximum in an x-ray-diffraction rocking curve characterization of the AlN seed crystal was a remarkably narrow 70 arcsec. In other words, the AlN seed crystal of Embodiment 3 was of tremendously high quality.

### 2. Growth of AlN single crystal (AlₓGa₁₋ₓN single crystal)

Next, apart from utilizing the just-described AlN seed crystal (Al*_{y}*Ga_{1-*y*}N seed crystal) of 25 mm crystal diameter *D* and 0.16 mm thickness *T*, AlN single crystal (Al*ₓ*Ga_{1-*x*}N single crystal 5) was grown in the same manner as in Embodiment 1. The size of the obtained AlN single crystal was 25 mm in crystal diameter and 4 mm in thickness. The diffraction-peak full-width at half-maximum in an x-ray-diffraction rocking curve characterization of the AlN single crystal was a remarkably narrow 70 arcsec. Meanwhile, the dislocation density of the AlN single crystal was a very low 6 × 10⁵ cm⁻². In other words, the AIN single crystal of Embodiment 3 was of tremendously high quality. The results are tabulated in Table I.

### Embodiment 4

### 1. Growth of AlN seed crystal (Al_{y}Ga_{1-y}N seed crystal)

Apart from having the AlN seed crystal (Al*_{y}*Ga_{1-*y*}N seed crystal) growth time be 10 hours, in the same manner as in Embodiment 3, a plurality of AlN seed crystals was grown. The size of a single AlN seed crystal among these AlN seed crystals was 14 mm in crystal diameter *D* and 0.18 mm in thickness *T*. The inclusion ratio of Si (Group IVB atoms) in the AIN seed crystal was 120 ppm. The diffraction-peak full-width at half-maximum in an x-ray-diffraction rocking curve characterization of the AIN seed crystal was a very narrow 80 arcsec. In other words, the AlN seed crystal of Embodiment 4 was of tremendously high quality.

### 2. Growth of AlN single crystal (AlₓGa₁₋ₓN single crystal)

Next, apart from utilizing the just-described AlN seed crystal (Al*_{y}*Ga_{1-*y*}N seed crystal) of 14 mm crystal diameter *D* and 0.18 mm thickness *T*, AlN single crystal (Al*ₓ*Ga_{1-*x*}N single crystal 5) was grown in the same manner as in Embodiment 1. The size of the obtained AlN single crystal was 14 mm in crystal diameter and 4 mm in thickness. The diffraction-peak full-width at half-maximum in an x-ray-diffraction rocking curve characterization of the AlN single crystal was a remarkably narrow 80 arcsec. Meanwhile, the dislocation density of the AlN single crystal was a very low 8 x 10⁵ cm⁻². In other words, the AlN single crystal of Embodiment 4 was of tremendously high quality. The results are tabulated in Table I.

### Embodiment 5

### 1. Growth of AlN seed crystal (Al_{y}Ga_{1-y}N seed crystal)

Apart from using powdered carbon (C) of 400 ppm inclusion ratio as a Group IVB element within the source materials, and from having the AlN seed crystal (Al*_{y}*Ga_{1-*y*}N seed crystal) growth time be 20 hours, in the same manner as in Embodiment 3, a plurality of AlN seed crystals was grown. The size of a single AlN seed crystal among these AlN seed crystals was 22 mm in crystal diameter *D* and 0.14 mm in thickness *T*. The inclusion ratio of C (Group IVB atoms) in the AlN seed crystal was determined by secondary-ion mass spectroscopy (SIMS), whereat it was 120 ppm. The diffraction-peak full-width at half-maximum in an x-ray-diffraction rocking curve characterization of the AlN seed crystal was an extremely narrow 25 arcsec. In other words, the AlN seed crystal of Embodiment 5 was of exceedingly high quality.

### 2. Growth of AlN single crystal (AlₓGa₁₋ₓN single crystal)

Next, apart from utilizing the just-described AlN seed crystal (Al*_{y}*Ga_{1-*y*}N seed crystal) of 22 mm crystal diameter *D* and 0.14 mm thickness *T*, AlN single crystal (Al*ₓ*Ga_{1-*x*}N single crystal 5) was grown in the same manner as in Embodiment 1. The size of the obtained AlN single crystal was 22 mm in crystal diameter and 4 mm in thickness. The diffraction-peak full-width at half-maximum in an x-ray-diffraction rocking curve characterization of the AlN single crystal was an extremely narrow 20 arcsec. Meanwhile, the dislocation density of the AlN single crystal was an extremely low 5 × 10⁴ cm⁻². In other words, the AlN single crystal of Embodiment 5 was of exceedingly high quality. The results are tabulated in Table I.

### Embodiment 6

### 1. Growth of AlN seed crystal (Al_{y}Ga_{1-y}N seed crystal)

Apart from using powdered C of 600 ppm inclusion ratio as a Group IVB element within the source materials, and from having the AlN seed crystal (Al*_{y}*Ga_{1-*y*}N seed crystal) growth time be 40 hours, in the same manner as in Embodiment 3, a plurality of AlN seed crystals was grown. The size of a single AlN seed crystal among these AlN seed crystals was 40 mm in crystal diameter *D* and 0.17 mm in thickness *T*. The inclusion ratio of C (Group IVB atoms) in the AlN seed crystal was 140 ppm. The diffraction-peak full-width at half-maximum in an x-ray-diffraction rocking curve characterization of the AlN seed crystal was an extremely narrow 20 arcsec. In other words, the AlN seed crystal of Embodiment 6 was of exceedingly high quality

### 2. Growth of AlN single crystal (AlₓGa₁₋ₓN single crystal)

Next, apart from utilizing the just-described AlN seed crystal (Al*_{y}*Ga_{1-*y*}N seed crystal) of 40 mm crystal diameter *D* and 0.17 mm thickness *T*, AlN single crystal (Al*ₓ*Ga_{1-*x*}N single crystal) was grown in the same manner as in Embodiment 1. The size of the obtained AlN single crystal was 40 mm in crystal diameter and 4 mm in thickness. The diffraction-peak full-width at half-maximum in an x-ray-diffraction rocking curve characterization of the AlN single crystal was an extremely narrow 15 arcsec. Meanwhile, the dislocation density of the AlN single crystal was an extremely low 9 × 10³ cm⁻². In other words, the AlN single crystal of Embodiment 6 was of exceedingly high quality. The results are tabulated in Table I.

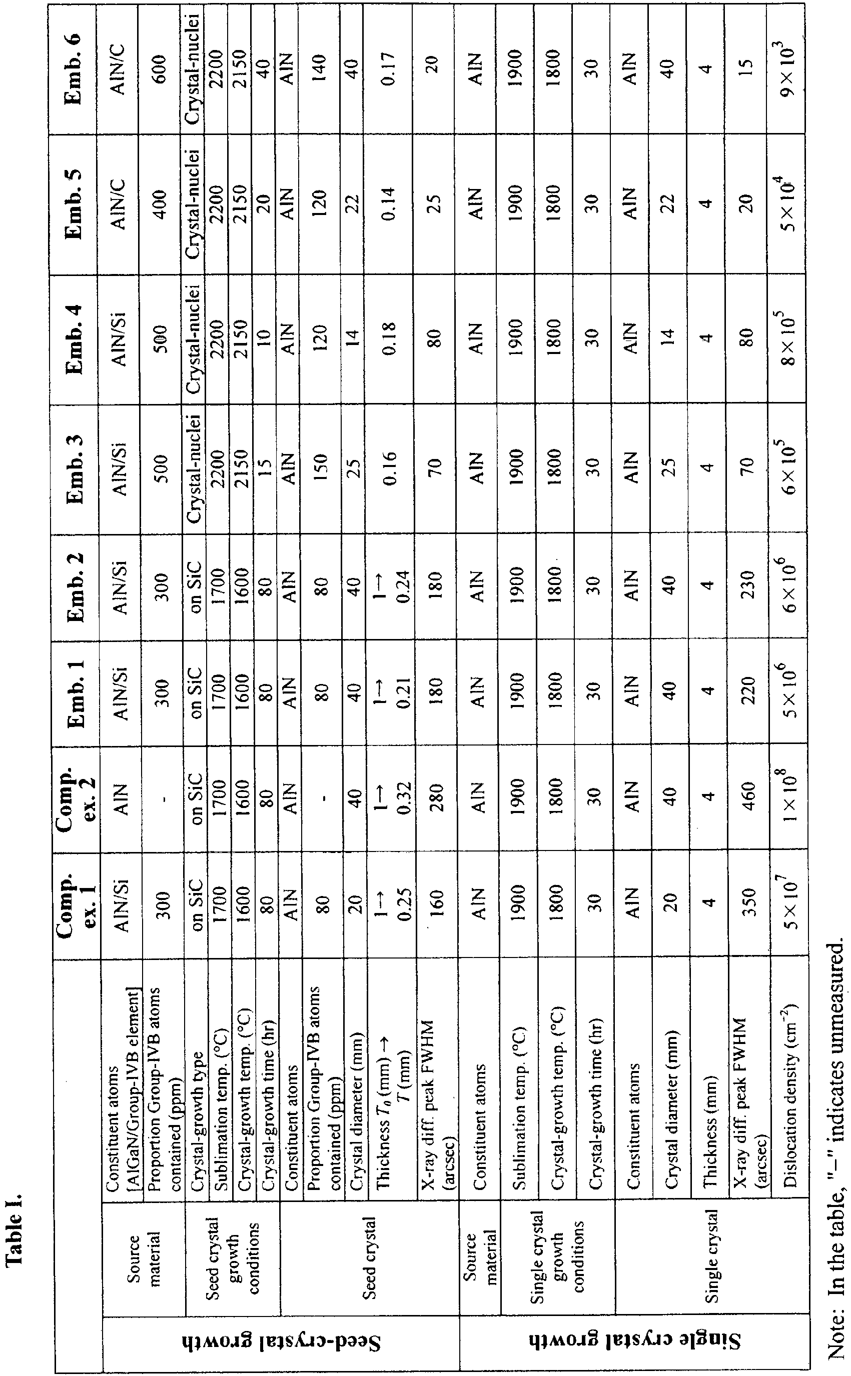

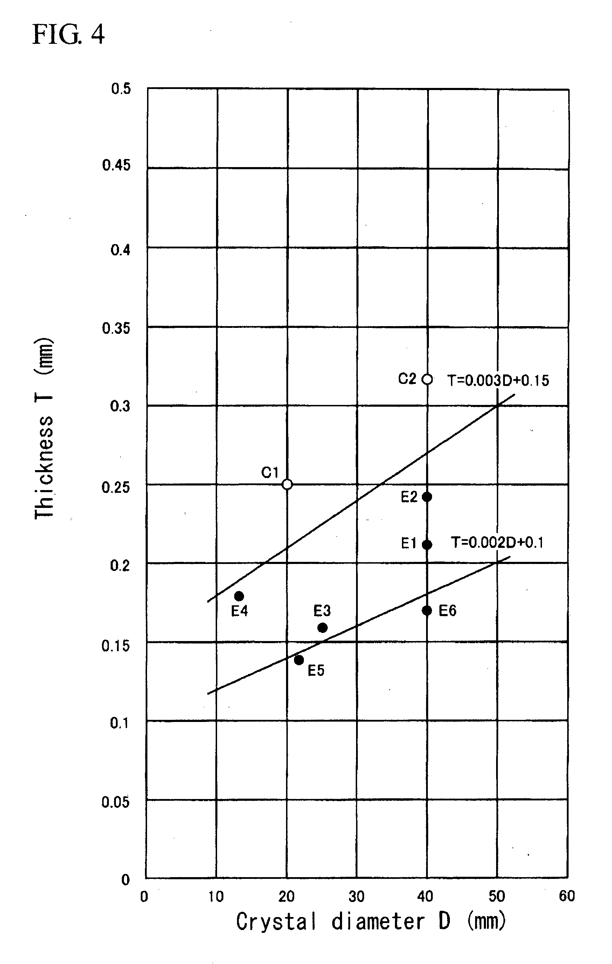

In addition, the relationship between the crystal diameter *D* (mm) and thickness *T* (mm) of the AlN seed crystal in Embodiment 1 through Embodiment 6 and Comparative Examples 1 and 2 in the foregoing Table I was plotted in Fig. 4 as E1 through E6, and C1 and C1, respectively.

Reference is made to Table I and Fig. 4: Compared with Comparative Example 1 (C1) and Comparative Example 2 (C2) for which the crystal diameter *D* (mm) and thickness *T* (mm) of the AlN seed crystal (Al*_{y}*Ga_{1-*y*}N seed crystal) were in the relation *T* ≥ 0.003*D* + 0.15, with Embodiment 1 (E1) through Embodiment 6 (E6), for which the crystal diameter *D* (mm) and thickness *T* (mm) of the AlN seed crystal (Al*_{y}*Ga_{1-*y*}N seed crystal) satisfied the relation *T* < 0.003D + 0.15, high-quality AlN single crystals (Al*ₓ*Ga_{1-*x*}N single crystals), wherein the diffraction-peak full-width at half-maximum in the x-ray-diffraction rocking curve characterizations was narrower and the dislocation density was lower, were obtained.

Furthermore, compared with Embodiment 1 (E1) through Embodiment 4 (E4), for which the crystal diameter *D* (mm) and thickness *T* (mm) of the AIN seed crystal (Al*_{y}*Ga_{1-*y*}N seed crystal) satisfied the relation 0.002*D* + 0.1 ≤ *T* < 0.003*D* + 0.15, with Embodiment 5 (E5) and Embodiment 6 (E6), for which the crystal diameter *D* (mm) and thickness *T* (mm) of the AlN seed crystal (Al*_{y}*Ga_{1-*y*}N seed crystal) satisfied the relation *T* < 0.002*D* + 0.1, still higher-quality AlN single crystals (Al*ₓ*Ga_{1-*x*}N single crystals), wherein the diffraction-peak full-width at half-maximum in the x-ray-diffraction rocking curve characterizations was even narrower and the dislocation density was even lower, were obtained.

Meanwhile, in Embodiment 1 (E1) through Embodiment 4 (E4), for which the crystal diameter *D* (mm) and thickness *T* (mm) of the AlN seed crystal (Al*_{y}*Ga_{1-*y*}N seed crystal) satisfied the relation 0.002*D* + 0.1 ≤ *T* < 0.003*D* + 0.15, compared with Embodiment 1 (E1) and Embodiment 2 (E2), in which AIN seed crystal (Al*_{y}*Ga_{1-*y*}N seed crystal) grown onto an SiC template crystal (template crystal) was utilized, with Embodiment 3 (E3) and Embodiment 4 (E4), in which AlN seed crystal wherein AlN-seed-crystal (Al*_{y}*Ga_{1-*y*}N seed-crystal) crystal nuclei were created and the crystal nuclei were grown was utilized, even higher-quality AlN single crystals (Al*ₓ*Ga_{1-*x*}N single crystals), wherein the diffraction-peak full-width at half-maximum in the x-ray-diffraction rocking curve characterizations was even narrower and the dislocation density was even lower, were obtained.

It should be understood that although in the foregoing embodiments and comparative examples an explanation of AIN seed crystal and AIN single crystal has been made, in respect also of Al*_{y}*Ga_{1-*y*}N (0 < *y* ≤ 1) seed crystal and Al*ₓ*Ga_{1-*x*}N (0 < *x* ≤ 1) single crystal, as long as Al is included as a constituent element of the crystal and the growth methods involving the present invention are applicable, similar results can of course be obtained.

The presently disclosed embodying modes and embodiment examples should in all respects be considered to be illustrative and not limiting. The scope of the present invention is set forth not by the foregoing description but by the scope of the patent claims, and is intended to include meanings equivalent to the scope of the patent claims and all modifications within the scope.

## Claims

1. A method of growing Al*ₓ*Ga₁₋ₓN single crystal, the method comprising:
a step of preparing an Al*_{y}*Ga_{1-*y*}N (0 < *y* ≤ 1) seed crystal whose crystal diameter *D* mm and thickness *T* mm satisfy the relation *T* < 0.003*D* + 0.15; and
a step of growing Al*ₓ*Ga_{1-*x*}N (0 < *x* ≤ 1) single crystal onto a major surface of the Al*_{y}*Ga_{1-*y*}N seed crystal by sublimation growth;
wherein the Al*_{y}*Ga_{1-*y*}N seed crystal contains, in mass ratio, 10 ppm or more of at least one type of atoms among the Group IVB elements.

2. The Al*ₓ*Ga_{1-*x*}N single crystal growth method set forth in claim 1, wherein crystal nuclei for the Al*_{y}*Ga_{1-*y*}N seed crystal are created by sublimation growth, and the crystal nuclei are grown into the Al*_{y}*Ga_{1-*y*}N seed crystal.

3. The Al*ₓ*Ga_{1-*x*}N single crystal growth method set forth in claim 1 or claim 2, wherein the Al*_{y}*Ga_{1-*y*}N seed crystal has a (0001) surface as its major surface.

## Patentansprüche

1. Verfahren zum Züchten eines Al*ₓ*Ga_{1-*x*}N Einkristalls, wobei das Verfahren umfasst:
einen Schritt zur Herstellung eines Al*_{y}*Ga_{1-*y*}N (0 <y ≤ 1) Impfkristalls, dessen Kristalldurchmesser D mm und Dicke T mm die Beziehung T < 0,003D + 0,15 erfüllen, und
einen Schritt des Aufwachsens des Al*ₓ*Ga_{1-*x*}N (0 <x ≤ 1) Einkristalls auf eine Hauptoberfläche des Al*_{y}*Ga_{1-*y*}N Impfkristalls durch Sublimationswachstum;
wobei der Al*_{y}*Ga_{1-*y*}N lmpfkristall, im Massenverhältnis, 10 ppm oder mehr von mindestens einer Art von Atomen der Gruppe IVB enthält.

2. Verfahren zum Züchten eines Al*ₓ*Ga_{1-*x*}N Einkristalls nach Anspruch 1, wobei Kristallkeime für den Al*_{y}*Ga_{1-*y*}N Impfkristall durch Sublimationswachstum erzeugt werden, und die Kristallkeime in den Al*_{y}*Ga_{1-*y*}N Impfkristall gewachsen werden.

3. Verfahren zum Züchten eines Al*ₓ*Ga_{1-*x*}N Einkristalls nach Anspruch 1 oder Anspruch 2, wobei der Al*_{y}*Ga_{1-*y*}N Impfkristall eine (0001)-Fläche als seine Hauptfläche aufweist

## Revendications

1. Procédé de croissance d'un monocristal de AlₓGa₁₋ₓN, le procédé comprenant :
une étape de préparation d'un germe cristallin de Al_{y}Ga_{1-y}N (0 < y ≤ 1) dont le diamètre de cristal *D* mm et l'épaisseur *T* mm satisfont la relation *T* < 0,003D + 0,15 ; et
une étape de croissance d'un monocristal de AlₓGa₁₋ₓN (0 < x ≤ 1) sur une surface majeure du germe cristallin de Al_{y}Ga_{1-y}N par croissance par sublimation ;
où le germe cristallin de Al_{y}Ga_{1-y}N contient, en rapport en masse, 10 ppm ou plus d'au moins un type d'atomes parmi les éléments du groupe IVB.

2. Procédé de croissance d'un monocristal de AlₓGa₁₋ₓN selon la revendication 1 où des noyaux cristallins pour le germe cristallin de Al_{y}Ga_{1-y}N sont créés par croissance par sublimation, et les noyaux cristallins sont amenés à croître en le germe cristallin de Al_{y}Ga_{1-y}N.

3. Procédé de croissance d'un monocristal de AlₓGa₁₋ₓN selon la revendication 1 ou la revendication 2 où le germe cristallin de Al_{y}Ga_{1-y}N a une surface (0001) comme surface majeure.
